# EUROPEAN PATENT APPLICATION

(11) **EP 4 815 646 A1**
(43) Date of publication of application: **30.09.2026**
(21) Application number: 25807375.8
(22) Date of filing: 06.03.2025
(51) Int. Cl.: H05K 3/46

(54) **MULTILAYER SUBSTRATE, METHOD FOR MANUFACTURING MULTILAYER SUBSTRATE, AND ELECTRONIC DEVICE**

(30) Priority: 24.05.2024 JP 2024085143
(71) Applicant: FICT LIMITED, Nagano-shi, Nagano 381-8501 (JP)
(72) Inventor: OZAKI, Norikazu, Nagano-shi, Nagano 381-8501 (JP); MIYAGAWA, Tetsurou, Nagano-shi, Nagano 381-8501 (JP); NAKAGAWA, Takashi, Nagano-shi, Nagano 381-8501 (JP); SAKAI, Naoki, Nagano-shi, Nagano 381-8501 (JP)
(74) Representative: Hoffmann Eitle
(86) International application number: PCT/JP2025/008091
(87) International publication number: WO 2025/243640

(57) **Abstract**

The present invention addresses the problem of providing a multilayer substrate that enables transmission of a metal layer at higher speeds without a chemically bonding coating having to be applied to the metal layer, a method for manufacturing the multilayer substrate, and an electronic device. As a solution, a plurality of laminated articles (56) are provided in layers, said laminate articles (56) having: a first insulating layer (26) in which a patterned first metal layer (40) is formed on a first surface (26a), a second insulating layer (24) laminated on a second surface (26b) of the first insulating layer (26), and formed by embedding a patterned second metal layer (22) on a third surface (24a); a third insulating layer (44) and a fourth insulating layer (48) laminated in the stated order on the first surface (26a) so as to embed the first metal layer (40); a first via (34) formed through the first insulating layer (26) and the second insulating layer (24); and a second via (54) formed through the third insulating layer (44) and the fourth insulating layer (48). At least the second insulating layer (24) and the fourth insulating layer (48) are made of a material having a low dielectric loss tangent.

## Description

### Technical Field

The present invention relates to a multilayer substrate, a method for manufacturing a multilayer substrate, and an electronic device.

### Background Art

Circuit boards with a multilayer structure (hereinafter sometimes referred to as "multilayer substrate") are generally well known.

For example, PTL 1 (JP-A-2021-190602) discloses a multilayer substrate in which multiple laminated bodies each including two metal layers are stacked. With conventional build-up type multilayer substrates, as the number of layers increases, the yield per layer is multiplied by the number of layers, which is reflected in the overall yield. The multilayer substrate disclosed in PTL 1 achieves improvement in the above yield by prefabricating laminated bodies.

### Citation List

### Patent Literature

PTL 1: JP-A-2021-190602

### Summary of Invention

### Technical Problem

Meanwhile, in multilayer substrates as disclosed in PTL 1, a chemical adhesion coating may be applied to the surface of a metal layer without performing a surface roughening treatment on the metal layer in order to achieve high-speed transmission of the metal layer. However, when an insulating layer is stacked on the metal layer to which the chemical adhesion coating is applied, and via holes are formed in the insulating layer using a laser or the like, the chemical adhesion coating at the via connection portion of the metal layer may not be completely removed, resulting in poor connection between the metal layer and vias. In other words, when a chemical adhesion coating is applied to a metal layer of a multilayer substrate, a problem arises in that the reliability of the multilayer substrate decreases.

### Solution to Problem

Accordingly, to solve the above issue, it is an objective of the present invention to provide a multilayer substrate, a method for manufacturing a multilayer substrate, and an electronic device that can achieve high-speed transmission of a metal layer without applying a chemical adhesion coating to the metal layer.

That is, a multilayer substrate of the disclosure requires that a plurality of laminated bodies each including: a first insulating layer having a first surface on which a patterned first metal layer is formed; a second insulating layer that is stacked on a second surface of the first insulating layer and has a third surface that is opposite to the first insulating layer and on which a patterned second metal layer is formed and embedded; a third insulating layer stacked on the first surface such that the first metal layer is embedded, and a fourth insulating layer stacked on the third insulating layer; a first via that is formed to extend through the first insulating layer and the second insulating layer and electrically connects the first metal layer and the second metal layer; and a second via formed to extend through the third insulating layer and the fourth insulating layer, are stacked, and at least the second insulating layer and the fourth insulating layer are made of a material with a low dielectric loss tangent.

Also, a multilayer substrate of the disclosure requires that a plurality of laminated bodies each including: a first insulating layer having a first surface on which a patterned first metal layer is formed; a second insulating layer that is stacked on a second surface of the first insulating layer and has a third surface that is opposite to the first insulating layer and on which a patterned second metal layer is formed and embedded; a fifth insulating layer stacked on the first surface such that the first metal layer is embedded, a sixth insulating layer stacked on the fifth insulating layer, and a seventh insulating layer stacked on the sixth insulating layer; a first via that is formed to extend through the first insulating layer and the second insulating layer and electrically connects the first metal layer and the second metal layer; and a second via formed to extend through the fifth insulating layer, the sixth insulating layer, and the seventh insulating layer, are stacked, and at least the second insulating layer, the fifth insulating layer, and the seventh insulating layer are made of a material with a low dielectric loss tangent.

Also, a multilayer substrate of the disclosure requires that a plurality of laminated bodies each including: a first insulating layer; an eighth insulating layer that is stacked on a first surface of the first insulating layer and has a fourth surface that is opposite to the first insulating layer and on which a patterned first metal layer is formed; a second insulating layer that is stacked on a second surface of the first insulating layer and has a third surface that is opposite to the first insulating layer and on which a patterned second metal layer is formed and embedded; a fifth insulating layer stacked on the fourth surface such that the first metal layer is embedded, a sixth insulating layer stacked on the fifth insulating layer, and a seventh insulating layer stacked on the sixth insulating layer; a first via that is formed to extend through the first insulating layer, the second insulating layer, and the eighth insulating layer and electrically connects the first metal layer and the second metal layer; and a second via formed to extend through the fifth insulating layer, the sixth insulating layer, and the seventh insulating layer, are stacked, and at least the second insulating layer, the fifth insulating layer, the seventh insulating layer, and the eighth insulating layer are made of a material with a low dielectric loss tangent.

Also, a method for manufacturing a multilayer substrate of the disclosure is required to include: a laminated body forming step of forming a laminated body by a second metal layer forming step of forming a second metal layer by performing etching on a three-layer metal foil, then, a first stacking step of stacking a second insulating layer on the second metal layer so as to embed the second metal layer, then, a second stacking step of stacking a first insulating layer on the second insulating layer, then, a first via forming step of forming a first via in the first insulating layer and the second insulating layer, then, a first metal layer forming step of forming a first metal layer on the first insulating layer, then, a third stacking step of stacking a third insulating layer such that the first metal layer is embedded, then, an etching step of removing a portion other than the second metal layer by performing etching on the three-layer metal foil, then, a fourth stacking step of stacking a fourth insulating layer on the third insulating layer, and then, a second via forming step of forming a second via in the third insulating layer and the fourth insulating layer; and a fifth stacking step of stacking a plurality of the laminated bodies, and that at least the second insulating layer and the fourth insulating layer are made of a material with a low dielectric loss tangent.

Also, a method for manufacturing a multilayer substrate of the disclosure is required to include: a laminated body forming step of forming a laminated body by a second metal layer forming step of forming a second metal layer by performing etching on a three-layer metal foil, then, a first stacking step of stacking a second insulating layer on the second metal layer so as to embed the second metal layer, then, a second stacking step of stacking a first insulating layer on the second insulating layer, then, a first via forming step of forming a first via in the first insulating layer and the second insulating layer, then, a first metal layer forming step of forming a first metal layer on the first insulating layer, then, a third stacking step of stacking a fifth insulating layer and a sixth insulating layer such that the first metal layer is embedded, then, an etching step of removing a portion other than the second metal layer by performing etching on the three-layer metal foil, then, a fourth stacking step of stacking a seventh insulating layer on the sixth insulating layer, and then, a second via forming step of forming a second via in the fifth insulating layer, the sixth insulating layer, and the seventh insulating layer; and a fifth stacking step of stacking a plurality of the laminated bodies, and that at least the second insulating layer, the fifth insulating layer, and the seventh insulating layer are made of a material with a low dielectric loss tangent.

Also, a method for manufacturing a multilayer substrate of the disclosure is required to include: a laminated body forming step of forming a laminated body by a second metal layer forming step of forming a second metal layer by performing etching on a three-layer metal foil, then, a first stacking step of stacking a second insulating layer on the second metal layer so as to embed the second metal layer, then, a second stacking step of stacking a first insulating layer and an eighth insulating layer on the second insulating layer, then, a first via forming step of forming a first via in the first insulating layer, the second insulating layer, and the eighth insulating layer, then, a first metal layer forming step of forming a first metal layer on the eighth insulating layer, then, a third stacking step of stacking a fifth insulating layer and a sixth insulating layer such that the first metal layer is embedded, then, an etching step of removing a portion other than the second metal layer by performing etching on the three-layer metal foil, then, a fourth stacking step of stacking a seventh insulating layer on the sixth insulating layer, and then, a second via forming step of forming a second via in the fifth insulating layer, the sixth insulating layer, and the seventh insulating layer; and a fifth stacking step of stacking a plurality of the laminated bodies, and that at least the second insulating layer, the fifth insulating layer, the seventh insulating layer, and the eighth insulating layer are made of a material with a low dielectric loss tangent.

Furthermore, the disclosed electronic device is required to include one of the multilayer substrates described above and an electronic component.

### Advantageous Effects of Invention

According to the present invention, it is possible to achieve a multilayer substrate, a method for manufacturing a multilayer substrate, and an electronic device that enable high-speed transmission of a metal layer without applying a chemical adhesion coating to the metal layer.

### Brief Description of Drawings

Fig. 1 is a schematic cross-sectional view showing an example of a method for manufacturing a multilayer substrate of a first embodiment (part 1).
Fig. 2 is a schematic cross-sectional view showing an example of a method for manufacturing a multilayer substrate of the first embodiment (part 2).
Fig. 3 is a schematic cross-sectional view showing an example of a method for manufacturing a multilayer substrate of the first embodiment (part 3).
Fig. 4 is a schematic cross-sectional view showing an example of a method for manufacturing a multilayer substrate of the first embodiment (part 4).
Fig. 5 is a schematic cross-sectional view showing an example of a method for manufacturing a multilayer substrate of the first embodiment (part 5).
Fig. 6 is a schematic cross-sectional view showing an example of a method for manufacturing a multilayer substrate of the first embodiment (part 6).
Fig. 7 is a schematic cross-sectional view showing an example of a method for manufacturing a multilayer substrate of the first embodiment (part 7).
Fig. 8 is a schematic cross-sectional view showing an example of a method for manufacturing a multilayer substrate of the first embodiment (part 8).
Fig. 9 is a schematic cross-sectional view showing an example of a method for manufacturing a multilayer substrate of the first embodiment (part 9).
Fig. 10 is a schematic cross-sectional view showing an example of a method for manufacturing a multilayer substrate of the first embodiment (part 10).
Fig. 11 is a schematic cross-sectional view showing an example of a method for manufacturing a multilayer substrate of the first embodiment (part 11).
Fig. 12 is a schematic cross-sectional view showing an example of a method for manufacturing a multilayer substrate of the first embodiment (part 12).
Fig. 13 is a schematic cross-sectional view showing an example of a method for manufacturing a multilayer substrate of the first embodiment (part 13).
Fig. 14 is a schematic cross-sectional view showing an example of a method for manufacturing a multilayer substrate of the first embodiment (part 14).
Fig. 15 is a schematic cross-sectional view showing an example of a method for manufacturing a multilayer substrate of the first embodiment (part 15).
Fig. 16 is a schematic cross-sectional view showing an example of a method for manufacturing a multilayer substrate of the first embodiment (part 16).
Fig. 17 is a schematic cross-sectional view showing an example of a method for manufacturing a multilayer substrate of the first embodiment (part 17).
Fig. 18 is a schematic cross-sectional view showing an example of a method for manufacturing a multilayer substrate of the first embodiment (part 18).
Fig. 19 is a schematic cross-sectional view showing an example of a method for manufacturing a multilayer substrate of the first embodiment (part 19).
Fig. 20 is a schematic cross-sectional view showing an example of a method for manufacturing a multilayer substrate of the first embodiment (part 20).
Fig. 21 is a schematic cross-sectional view showing an example of a method for manufacturing a multilayer substrate of the first embodiment (part 21).
Fig. 22 is a schematic cross-sectional view showing an example of a method for manufacturing a multilayer substrate of the first embodiment (part 22).
Fig. 23 is a schematic cross-sectional view showing an example of a method for manufacturing a multilayer substrate of a second embodiment (part 23).
Fig. 24 is a schematic cross-sectional view showing an example of a method for manufacturing a multilayer substrate of the second embodiment (part 24).
Fig. 25 is a schematic cross-sectional view showing an example of a method for manufacturing a multilayer substrate of the second embodiment (part 25).
Fig. 26 is a schematic cross-sectional view showing an example of a method for manufacturing a multilayer substrate of the second embodiment (part 26).
Fig. 27 is a schematic cross-sectional view showing an example of a method for manufacturing a multilayer substrate of the second embodiment (part 27).
Fig. 28 is a schematic cross-sectional view showing an example of a method for manufacturing a multilayer substrate of the second embodiment (part 28).
Fig. 29 is a schematic cross-sectional view showing an example of a method for manufacturing a multilayer substrate of the second embodiment (part 29).
Fig. 30 is a schematic cross-sectional view showing an example of a method for manufacturing a multilayer substrate of the second embodiment (part 30).
Fig. 31 is a schematic cross-sectional view showing an example of a method for manufacturing a multilayer substrate of the second embodiment (part 31).
Fig. 32 is a schematic cross-sectional view showing an example of a method for manufacturing a multilayer substrate of a third embodiment (part 32).
Fig. 33 is a schematic cross-sectional view showing an example of a method for manufacturing a multilayer substrate of the third embodiment (part 33).
Fig. 34 is a schematic cross-sectional view showing an example of a method for manufacturing a multilayer substrate of the third embodiment (part 34).
Fig. 35 is a schematic cross-sectional view showing an example of a method for manufacturing a multilayer substrate of the third embodiment (part 35).
Fig. 36 is a schematic cross-sectional view showing an example of a method for manufacturing a multilayer substrate of the third embodiment (part 36).
Fig. 37 is a schematic cross-sectional view showing an example of a method for manufacturing a multilayer substrate of the third embodiment (part 37).
Fig. 38 is a schematic cross-sectional view showing an example of a method for manufacturing a multilayer substrate of the third embodiment (part 38).
Fig. 39 is a schematic cross-sectional view showing an example of a method for manufacturing a multilayer substrate of the third embodiment (part 39).
Fig. 40 is a schematic cross-sectional view showing an example of a method for manufacturing a multilayer substrate of the third embodiment (part 40).
Fig. 41 is a schematic cross-sectional view showing an example of a method for manufacturing a multilayer substrate of the third embodiment (part 41).
Fig. 42 is a schematic cross-sectional view showing an example of a method for manufacturing a multilayer substrate of the third embodiment (part 42).
Fig. 43 is a schematic cross-sectional view showing an example of a method for manufacturing a multilayer substrate of the third embodiment (part 43).
Fig. 44 is a schematic cross-sectional view showing an example of a method for manufacturing a multilayer substrate of the third embodiment (part 44).
Fig. 45 is a schematic cross-sectional view showing an example of a method for manufacturing a multilayer substrate of the third embodiment (part 45).
Fig. 46 is a schematic cross-sectional view showing an example of a method for manufacturing a multilayer substrate of the third embodiment (part 46).
Fig. 47 is a schematic cross-sectional view of a semiconductor package.

### Description of Embodiments

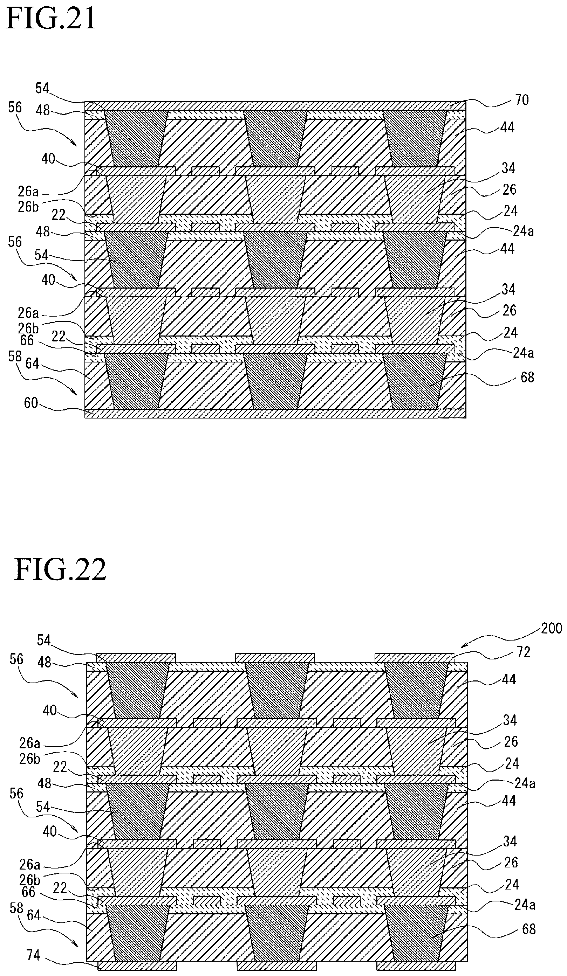

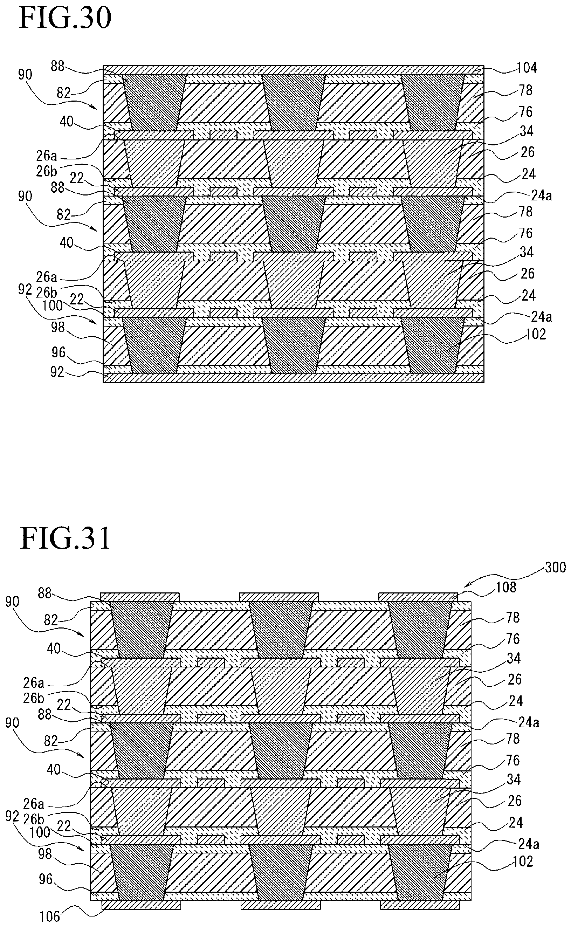

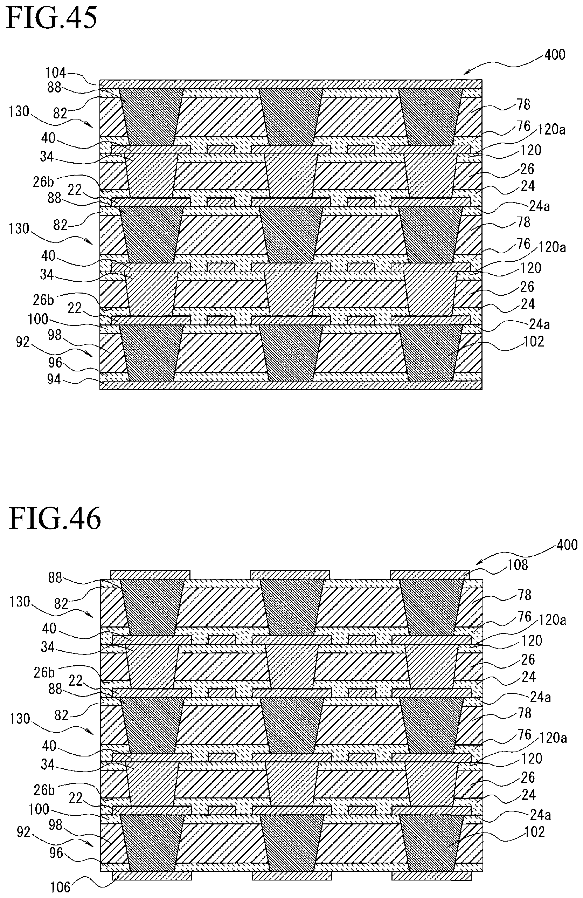

Multilayer substrates 200, 300, and 400 of embodiments are described in detail below with reference to the drawings. Fig. 22 is a diagram showing an example of a method for manufacturing a multilayer substrate 200 of a first embodiment, and is a schematic cross-sectional view of the multilayer substrate 200. Fig. 31 is a diagram showing an example of a method for manufacturing a multilayer substrate 300 of a second embodiment, and is a schematic cross-sectional view of the multilayer substrate 300. Fig. 46 is a diagram showing an example of a method for manufacturing a multilayer substrate 400 of a third embodiment, and is a schematic cross-sectional view of the multilayer substrate 400. In all the drawings for illustrating the embodiments, the same reference numerals are used to designate components having the same functions, and repeated explanations thereof may be omitted.

In the multilayer substrates 200, 300, and 400, for convenience, the terms "upper layer" or "lower layer" may be used based on an up-down direction in the drawings. However, the upper or lower layer in the multilayer substrates 200, 300, and 400 may not necessarily correspond to the actual orientation in the up-down direction.

Also, in the multilayer substrates 200, 300, and 400, for convenience, the terms "upper surface" or "lower surface" may be used based on an up-down direction in the drawings. However, the upper or lower surfaces in the multilayer substrates 200, 300, and 400 may not necessarily correspond to the actual orientation in the up-down direction. Furthermore, in the multilayer substrates 200, 300, and 400, the term "side surface" may be used, and the side surface means the side surface with respect to the "upper surface" and "lower surface" described above.

### <First Embodiment>

### <<Multilayer Substrate>>

As shown in Fig. 22, the multilayer substrate 200 of the first embodiment has a configuration in which a plurality of laminated bodies 56 are stacked. More specifically, the multilayer substrate 200 includes the plurality of laminated bodies 56, a metal layer 72 located at the uppermost layer, and a laminated body 58 located at the lowermost layer.

### <<<First Insulating Layer>>>

Each laminated body 56 includes a first insulating layer 26 having a first surface 26a on which a patterned first metal layer 40 is formed.

The first insulating layer 26 generally has the shape of a flat plate. In one example, the average thickness of the first insulating layer 26 may be 10 µm or more and 200 µm or less, or 30 µm or more and 100 µm or less, but it is not particularly limited and can be appropriately selected depending on the purpose.

Also, the first insulating layer 26 is not particularly limited as long as it is an insulating layer used in a multilayer substrate, and can be appropriately selected depending on the purpose. The first insulating layer 26 may use, in one example, a base material whose hardness is reinforced by an inorganic base material such as an inorganic woven fabric or an inorganic nonwoven fabric using glass cloth or the like, or by an organic base material such as an organic woven fabric or an organic nonwoven fabric.

More specifically, the first insulating layer 26 may use, as one example, a glass epoxy base material (a glass woven-fabric base material impregnated with an epoxy resin, or a glass nonwoven-fabric base material impregnated with an epoxy resin), a glass woven-fabric base material impregnated with a bismaleimide triazine resin, an aramid nonwoven-fabric base material impregnated with an epoxy resin, or a glass woven-fabric base material impregnated with a modified polyphenylene ether resin.

At least a second insulating layer 24 and a fourth insulating layer 48, which will be described below, are made of a material with a low dielectric loss tangent, but the first insulating layer 26 may also be made of a material with a low dielectric loss tangent described below. This makes it possible to further increase the transmission speed of the multilayer substrate 200. Also, when a material with a low dielectric loss tangent is used for the first insulating layer 26, the first insulating layer 26 is configured to be in close contact with first vias 34, which will be described below.

### <<<First Metal Layer>>>

A predetermined patterned first metal layer 40 is formed on the first surface of the first insulating layer 26 (the upper surface of the first insulating layer 26 in Fig. 22). In one example, the first metal layer 40 is formed to have a thickness of approximately 10 µm to 60 µm, but is not limited to this and can be appropriately selected depending on the purpose.

Furthermore, while the first metal layer 40 is preferably subjected to a surface roughening treatment, it is not limited to this and can be appropriately selected depending on the purpose.

### <<<Second Insulating Layer>>>

The second insulating layer 24 is stacked on the second surface of the first insulating layer 26 (the lower surface of the first insulating layer 26 in Fig. 22, which is the surface opposite to the first surface 26a).

Also, the average thickness of the second insulating layer 24 may be, in one example, 10 µm or more and 200 µm or less, or 30 µm or more and 100 µm or less, but it is not particularly limited and can be appropriately selected depending on the purpose.

Furthermore, the second insulating layer 24 is made of a material with a low dielectric loss tangent. A material with a low dielectric loss tangent as used herein refers to, for example, a material (specifically, a resin material) having a dielectric loss tangent of 0.002 or less at 10 GHz. Thus, the second insulating layer 24 preferably has a dielectric loss tangent of 0.002 or less at 10 GHz. Furthermore, a material with a low dielectric loss tangent as used herein also refers to a material that exhibits adhesion to a metal layer that is not subjected to a roughening treatment. As such, the second insulating layer 24 is preferably made of a material that exhibits adhesion to a metal layer that is not subjected to a roughening treatment. That is, the second insulating layer 24 is in close contact with a second metal layer 22, which will be described below. Furthermore, while there is no particular limitation on the lower limit of the dielectric loss tangent, it is usually 0.0009 or more.

### <<<Second Metal Layer>>>

A predetermined patterned second metal layer 22 is formed on the third surface 24a of the second insulating layer 24 (the lower surface of the second insulating layer 24 in Fig. 22, which is the surface opposite to the first insulating layer 26 facing the second insulating layer 24). More specifically, on the third surface of the second insulating layer 24, a predetermined patterned second metal layer 22 is formed and embedded. In one example, the second metal layer 22 is formed to have a thickness of approximately 10 µm to 60 µm, but is not limited to this and can be appropriately selected depending on the purpose.

Also, the second metal layer 22 is preferably not subjected to a surface roughening treatment. As a result, the surface of the second metal layer 22 has a structure without fine irregularities, thus preventing transmission delays caused by such irregularities.

As described above, since the second metal layer 22 is covered and in close contact with the second insulating layer 24, high-speed transmission of the second metal layer 22 can be achieved without applying a chemical adhesion coating to the second metal layer 22.

### <<<Third Insulating Layer>>>

A third insulating layer 44 is stacked on the first surface 26a of the first insulating layer 26 such that the first metal layer 40 is embedded.

The third insulating layer 44 is not particularly limited as long as it is an insulating base material used in a multilayer substrate, and can be appropriately selected depending on the purpose. More specifically, in one example, the third insulating layer 44 may use a thermosetting resin. As the thermosetting resin, fluororesin, polyphenylene ether resin (PPE/PPO resin), polyimide resin (PI resin), and bismaleimide triazine resin (BT resin) are preferred.

The third insulating layer 44 may use a base material whose hardness is reinforced by an inorganic base material such as an inorganic woven fabric or an inorganic nonwoven fabric using glass cloth or the like, or by an organic base material such as an organic woven fabric or an organic nonwoven fabric. More specifically, the third insulating layer 44 may be a glass epoxy base material, a glass woven fabric base material impregnated with bismaleimide triazine resin, an aramid nonwoven fabric base material impregnated with epoxy resin, a glass woven fabric base material impregnated with modified polyphenylene ether resin, and the like.

The material of the third insulating layer 44 may have a low dielectric loss tangent. This makes it possible to further increase the transmission speed of the multilayer substrate 200. When a material with a low dielectric loss tangent is used for the third insulating layer 44, the third insulating layer 44 is in close contact with second vias 54, which will be described below.

### <<<Fourth Insulating Layer>>>

Furthermore, the fourth insulating layer 48 is stacked on the third insulating layer 44.

The fourth insulating layer 48 is made of a material with a low dielectric loss tangent. More specifically, the fourth insulating layer 48 preferably has a dielectric loss tangent of 0.002 or less at 10 GHz. Also, the fourth insulating layer 48 is preferably made of a material that exhibits adhesion to a metal layer that is not subjected to a roughening treatment. That is, the fourth insulating layer 48 is in close contact with the second metal layer 22 of another laminated body. In one example, as the fourth insulating layer 48, the same material as the second insulating layer 24 described above may be used, but is not limited to this and can be appropriately selected depending on the purpose.

Furthermore, as will be described below, the fourth insulating layer 48 is in a semi-cured state when multiple laminated bodies 56 are stacked, and it serves as an adhesive layer.

### <<<First Via>>>

In the first insulating layer 26 and the second insulating layer 24, through-holes 32 extending through the first insulating layer 26 and the second insulating layer are formed, a first via 34 is formed in each through-hole 32 to electrically connect the first metal layer 40 and the second metal layer 22.

In one example, the size (opening diameter) of the through-hole 32 may be 50 µm or more and 500 µm or less, or 100 µm or more and 300 µm or less, but it is not limited to these and can be appropriately selected depending on the purpose.

In one example, the through-hole 32 is formed in a shape in which its diameter gradually decreases from the side from which the hole is formed (tapered shape), but is not limited to this and can be appropriately selected depending on the purpose. In another example, the through-hole 32 may be a through-hole formed perpendicular to the first insulating layer 26 and the second insulating layer 24.

The through-hole 32 is filled with the first via 34. In one example, the first via 34 is a plated via including copper, but is not limited to this and can be appropriately selected depending on the purpose.

In another example, the first via 34 may be conductive paste. In one example, as the conductive paste, a paste containing a conductive filler and a binder resin may be used, but it is not limited to this and can be appropriately selected depending on the purpose. In one example, as the conductive filler, metal particles such as copper, gold, silver, palladium, nickel, tin, and bismuth may be used, and these metal particles may be used alone or in combination of two or more types. Furthermore, in one example, as the binder resin, an epoxy resin or a polyimide resin, which is a type of thermosetting resin, may be used, but it is not limited to these and can be appropriately selected depending on the purpose.

### <<<Second Via>>>

Also, in the third insulating layer 44 and the fourth insulating layer 48, through-holes 52 extending through the third insulating layer 44 and the fourth insulating layer are formed, a second via 54 is formed in each through-hole 52 to electrically connect the first metal layer 40 and the second metal layer 22 of another laminated body 56 or the metal layer 72.

Furthermore, the size (opening diameter) of the through-hole 52 may be 50 µm or more and 500 µm or less, or 100 µm or more and 300 µm or less, for example, but it is not limited to these and can be appropriately selected depending on the purpose.

In one example, the through-hole 52 is formed in a shape in which its diameter gradually decreases from the side from which the hole is formed (tapered shape), but is not limited to this and can be appropriately selected depending on the purpose. In another example, the through-hole 52 may be a through-hole formed perpendicular to the third insulating layer 44 and the fourth insulating layer 48.

The through-hole 52 is filled with the second via 54. In one example, the second via 54 may be the conductive paste described as the first via 34, but is not limited to this and can be appropriately selected depending on the purpose. In another example, the second via 54 may be a plated via as described as the first via 34.

### <<<Metal Layer>>>

Furthermore, a predetermined patterned metal layer 72 is formed on the upper surface of the laminated body 56 at the uppermost layer. The metal layer 72 is formed to have a thickness of approximately 10 µm to 60 µm, for example, but is not limited to this and can be appropriately selected depending on the purpose.

### <<<Lowermost Layer of Laminated Body>>>

When the number of the metal layers is an even number, the multilayer substrate 200 includes the laminated body 58 at the lowermost layer. In one example, the laminated body 58 includes a ninth insulating layer 64 having a lower surface on which a patterned third metal layer 74 is formed, a tenth insulating layer 66 stacked on the ninth insulating layer 64, and third vias 68 formed to extend through the ninth insulating layer 64 and the tenth insulating layer 66. Also, the third metal layer 74 is electrically connected to the second metal layer 22 of the laminated body 56 located directly above the third metal layer 74 through the third vias 68.

The ninth insulating layer 64 may be similar to the first insulating layer 26 described above, and the tenth insulating layer 66 may be similar to the fourth insulating layer 48 described above. Also, the third metal layer 74 may be similar to the first metal layer 40 or the second metal layer 22 described above, but the third metal layer 74 is preferably exposed from the ninth insulating layer 64. Furthermore, the third vias 68 may be similar to the first vias 34 or the second vias 54 described above.

When the number of the metal layers of the multilayer substrate 200 is an odd number, the laminated body 58 is not stacked, and the configuration of the laminated body 56 at the lowermost layer is different (not shown). That is, the metal layer 22 of the laminated body 56 at the lowermost layer is preferably exposed from the second insulating layer 24.

The multilayer substrate 200 of the present embodiment described above can achieve high-speed transmission without requiring a roughening treatment or a chemical adhesion coating on the second metal layer 22. In particular, it is advantageous when the second metal layer 22 is used as a signal layer and the first metal layer 40 is used as a ground layer, as in the multilayer substrate 200 of the present embodiment.

### <<Method for Manufacturing Multilayer Substrate>>

The method for manufacturing the multilayer substrate 200 of the first embodiment is now described in detail. The method for manufacturing the multilayer substrate 200 includes a laminated body forming step of forming a laminated body 56 and a fifth stacking step of stacking a plurality of laminated bodies 56.

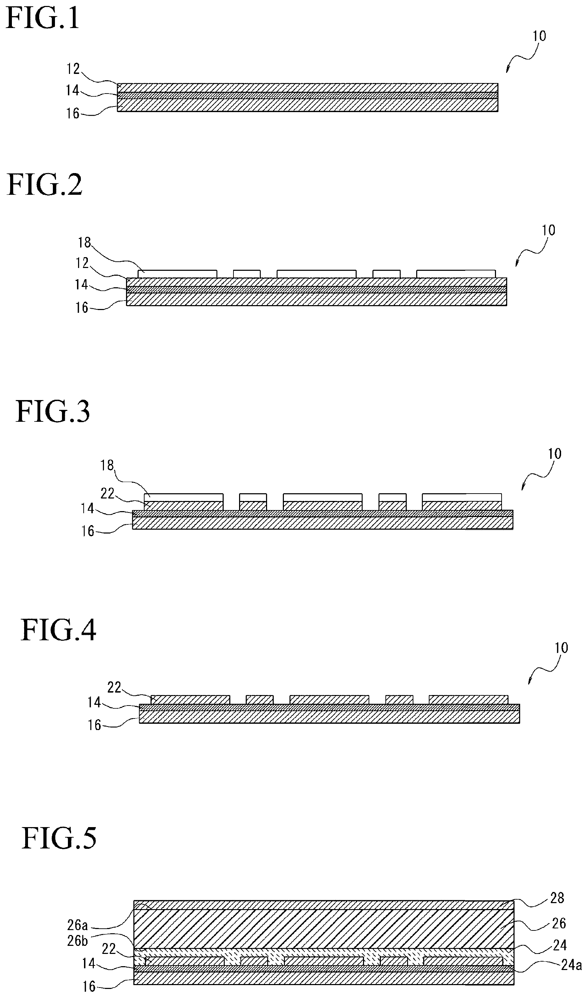

As shown in Fig. 1, a three-layer metal foil 10 is first prepared. In one example, the three-layer metal foil 10 includes a copper foil 12, a metal foil 14 different from the copper foil 12, and a metal support (specifically, a copper support) 16 stacked in this order. The metal foil 14 is not particularly limited as long as it is a metal that can be selectively etched with a selective etchant that does not react with the copper foil 12 or the copper support 16, and can be appropriately selected depending on the purpose.

Then, as shown in Figs. 2 to 4, the second metal layer 22 is formed on the three-layer metal foil 10 (second metal layer forming step). Specifically, as shown in Fig. 2, a film-shaped dry film resist 18 is affixed to the surface of the copper foil 12, and the dry film resist 18 is exposed to light using a predetermined pattern corresponding to the pattern of the second metal layer 22 to remove unnecessary portions. Then, as shown in Fig. 3, etching (half-etching) is performed to form the metal foil 12 into the second metal layer 22 in a predetermined pattern. Then, as shown in Fig. 4, the dry film resist 18 is removed from the surface of the second metal layer 22.

Then, as shown in Fig. 5, a second insulating layer (specifically, an uncured second insulating layer) 24 is stacked on the second metal layer 22 so as to embed the second metal layer 22 (first stacking step). Then, a first insulating layer (specifically, an uncured first insulating layer) 26 and a metal foil 28 are stacked on the second insulating layer 24 in this order (second stacking step).

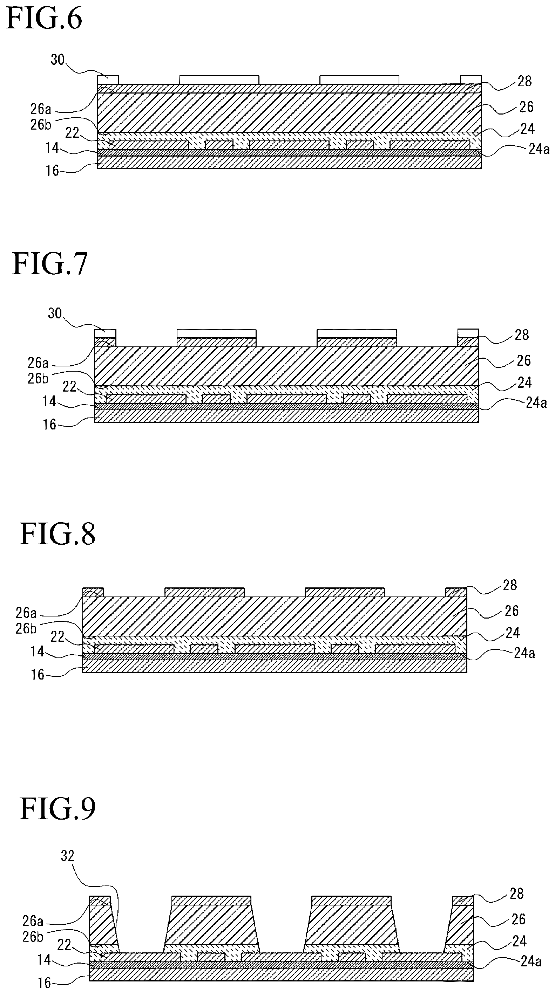

Then, as shown in Figs. 6 to 10, first vias 34 are formed in the first insulating layer 26 and the second insulating layer 24 (first via forming step).

Specifically, first, as shown in Fig. 6, a film-shaped dry film resist 30 is affixed to the surface of the metal foil 28, and the areas corresponding to openings of through-holes 32 of first vias 34 are exposed to light to remove unnecessary portions. Then, as shown in Fig. 7, etching (half-etching) is performed to form a metal layer 28 from the metal layer 28 in areas other than those corresponding to the through-holes 32. Then, as shown in Fig. 8, the dry film resist 30 is removed from the surface of the metal layer 28.

Then, as shown in Fig. 9, through-holes 32 are formed in the first insulating layer 26 and the second insulating layer 24. In one example, the through-holes 32 can be formed by laser processing. The types of laser processing include CO₂ laser, YAG laser, and the like, but they are not limited to these and can be appropriately selected depending on the purpose.

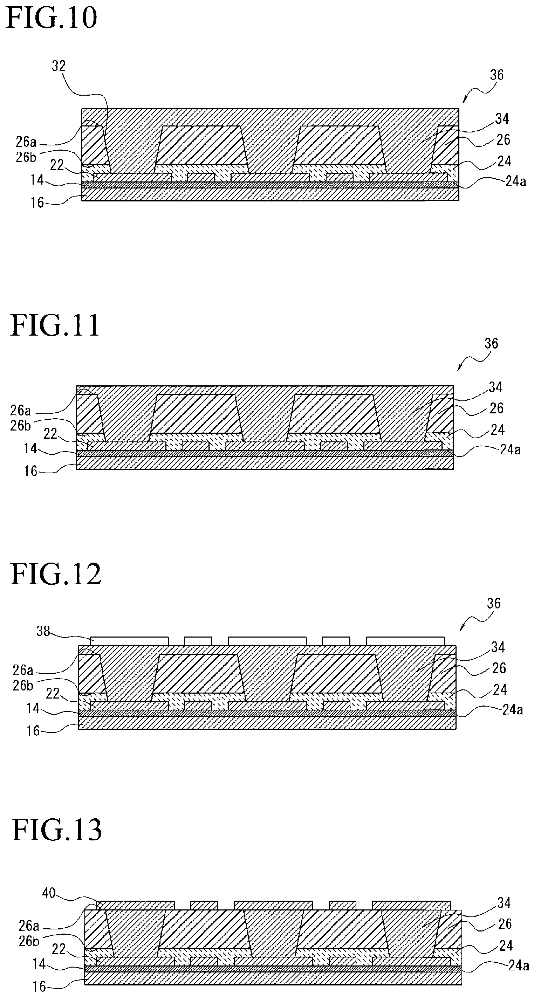

Then, as shown in Fig. 10, plating (copper plating) 34 is applied to the through-holes 32 by a plating process to form first vias (plated vias) 34. Instead of plated vias, a conductive paste may be used for filling.

When the first vias 34 are plated vias, the metal layer on the first surface 26a of the first insulating layer 26 may become too thick. In this case, as shown in Fig. 11, it is preferable to adjust the metal layer to a predetermined thickness by half-etching.

Then, as shown in Figs. 12 to 13, a first metal layer 40 is formed on the first surface 26a of the first insulating layer 26 (first metal layer forming step). Specifically, as shown in Fig. 12, a film-shaped dry film resist 38 is affixed to the surface of the metal layer 28, and the dry film resist 38 is exposed to light using a predetermined pattern corresponding to the pattern of the first metal layer 40 to remove unnecessary portions. Then, as shown in Fig. 13, etching (half-etching) is performed to form the metal layer 28 into the first metal layer 40 of a predetermined pattern and remove the dry film resist 18 from the surface of the first metal layer 40.

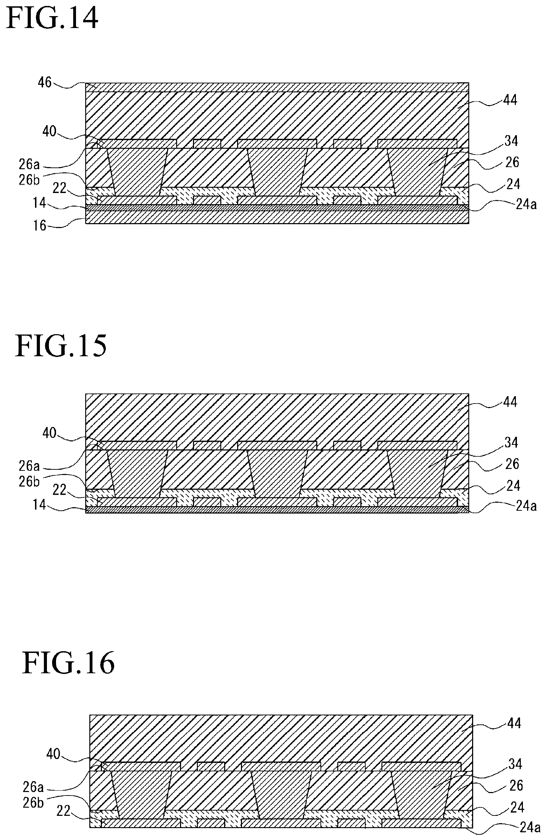

Then, as shown in Fig. 14, the third insulating layer 44 is stacked on the first insulating layer 26 such that the first metal layer 40 is embedded (third stacking step). Furthermore, a metal layer 46 is stacked on the third insulating layer 44. This ensures the flatness of the third insulating layer 44 and improves the reliability of the multilayer substrate.

Then, as shown in Fig. 15, after removing the metal layer 46 and the metal support 16 by etching, the metal foil 14 is removed (etching step) by etching (specifically, selective etching) as shown in Fig. 16.

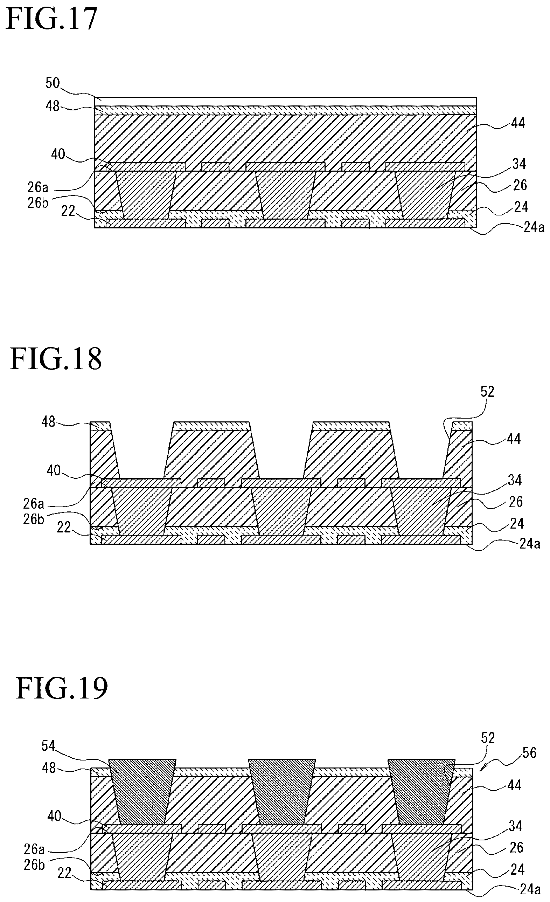

Then, as shown in Fig. 17, the fourth insulating layer 48 is stacked on the third insulating layer 44 (fourth stacking step). More specifically, the semi-cured fourth insulating layer 48 and a resin film 50 are stacked in this order on the third insulating layer 44.

Then, as shown in Figs. 18 to 19, second vias 54 are formed in the third insulating layer 44 and the fourth insulating layer 48 (second via forming step). Specifically, as shown in Fig. 18, through-holes 52 are formed in the third insulating layer 44 and the fourth insulating layer 48. In one example, the through-holes 52 can be formed by laser processing. The types of laser processing include CO₂ laser, YAG laser, and the like, but they are not limited to these and can be appropriately selected depending on the purpose. Then, as shown in Fig. 19, the through-holes 52 are filled with conductive paste 54. The laminated body 56 is completed through the steps described above.

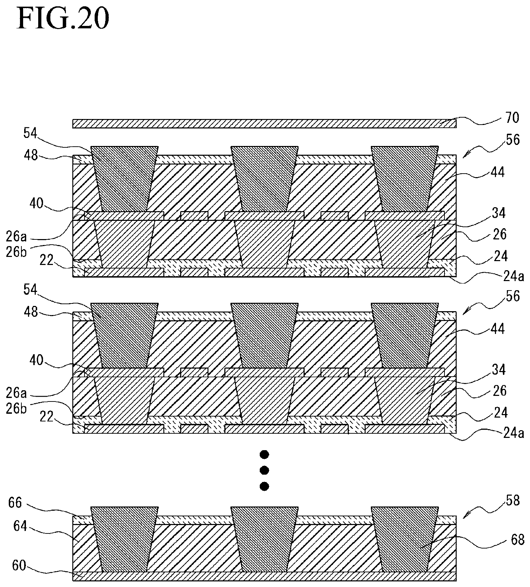

Then, as shown in Figs. 20 and 21, multiple laminated bodies 56 are stacked (fifth stacking step). More specifically, when the multilayer substrate 200 includes an even number of layers, the laminated body 58, multiple laminated bodies 56, and a metal layer 70 are stacked in this order and thermocompression-bonded. Furthermore, when the multilayer substrate 200 includes an odd number of layers, a laminated body (not shown) in which the second metal layer 22 is exposed from the second insulating layer 24 before etching, multiple laminated bodies 56, and the metal layer 70 are stacked in this order and then thermocompression-bonded. In either of the above cases, the second vias 54 in one laminated body 56 are electrically connected to the metal layer 70 or the second metal layer 22 of another laminated body 56.

Then, as shown in Fig. 22, etching is performed to form the metal layer 70 and the metal layer 60 of the multilayer substrate 200 after stacking (after thermocompression bonding) into the metal layer 72 and a metal layer 74 of a predetermined pattern.

### <Second Embodiment>

### <<Multilayer Substrate>>

The multilayer substrate 300 of a second embodiment is now described in detail. The multilayer substrate 300 of the second embodiment includes a fifth insulating layer 76, a sixth insulating layer 78, and a seventh insulating layer 82 instead of the third insulating layer 44 and the fourth insulating layer 48 of the multilayer substrate 200 of the first embodiment. Also, at least the second insulating layer 24, the fifth insulating layer 76, and the seventh insulating layer 82 are made of a material with a low dielectric loss tangent. Other than the above, the configuration of the multilayer substrate 300 is similar to that of the multilayer substrate 200. The fifth insulating layer 76, the sixth insulating layer 78, and the seventh insulating layer 82 are described below.

### <<<Fifth Insulating Layer>>>

The fifth insulating layer 76 is stacked on the first surface 26a of the first insulating layer 26 such that the first metal layer 40 is embedded.

The fifth insulating layer 76 is made of a material with a low dielectric loss tangent. More specifically, it is preferable that the fifth insulating layer 76 has a dielectric loss tangent of 0.002 or less at 10 GHz. Also, the fifth insulating layer 76 is preferably made of a material that exhibits adhesion to a metal layer that is not subjected to a roughening treatment. In other words, the fifth insulating layer 76 is in close contact with the first metal layer 40. In one example, as the fifth insulating layer 76, the same material as the second insulating layer 24 described above may be used, but is not limited to this and can be appropriately selected depending on the purpose.

In the present embodiment, the first metal layer 40 is preferably not subjected to a roughening treatment.

### <<<Sixth Insulating Layer>>>

The sixth insulating layer 78 is stacked on the surface of the fifth insulating layer 76. The sixth insulating layer 78 may have a configuration similar to that of the first insulating layer 26.

### <<<Seventh Insulating Layer>>>

The seventh insulating layer 82 is stacked on the surface of the sixth insulating layer 78. The seventh insulating layer 82 may have a configuration similar to that of the fourth insulating layer 48.

The multilayer substrate 300 of the present embodiment described above can achieve high-speed transmission of each metal layer without requiring a roughening treatment or a chemical adhesion coating on the first metal layer 40 and the second metal layer 22.

### <<Method for Manufacturing Multilayer Substrate>>

The method for manufacturing a multilayer substrate of the second embodiment is now described in detail. The method for manufacturing the multilayer substrate 300 includes a laminated body forming step of forming a laminated body 90 and a fifth stacking step of stacking a plurality of laminated bodies 90. The method for manufacturing the multilayer substrate 300 of the second embodiment differs from the method for manufacturing the multilayer substrate of the first embodiment in the steps from the third stacking step, but the other configurations are similar to those of the method for manufacturing the multilayer substrate 200 of the first embodiment.

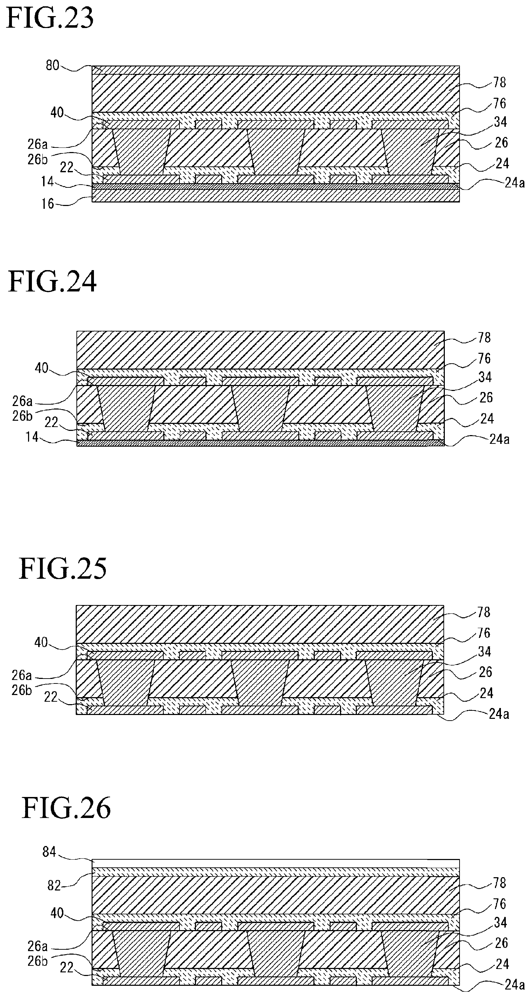

In the method for manufacturing a multilayer substrate of the second embodiment, following the first metal layer forming step, the fifth insulating layer 76 and the sixth insulating layer 78 are stacked on the first insulating layer 26 such that the first metal layer 40 is embedded as shown in Fig. 23 (third stacking step). Furthermore, a metal layer 80 is stacked on the sixth insulating layer 78. This ensures the flatness of the fifth insulating layer 76 and the sixth insulating layer 78 and improves the reliability of the multilayer substrate.

Then, as shown in Fig. 24, after removing the metal layer 80 and the metal support 16 by etching, etching (specifically, selective etching) is performed to remove the metal foil 14 as shown in Fig. 25 (etching step).

Then, as shown in Fig. 26, the seventh insulating layer 82 is stacked on the sixth insulating layer 78 (fourth stacking step). More specifically, the semi-cured seventh insulating layer 82 and a resin film 84 are stacked in this order on the sixth insulating layer 78.

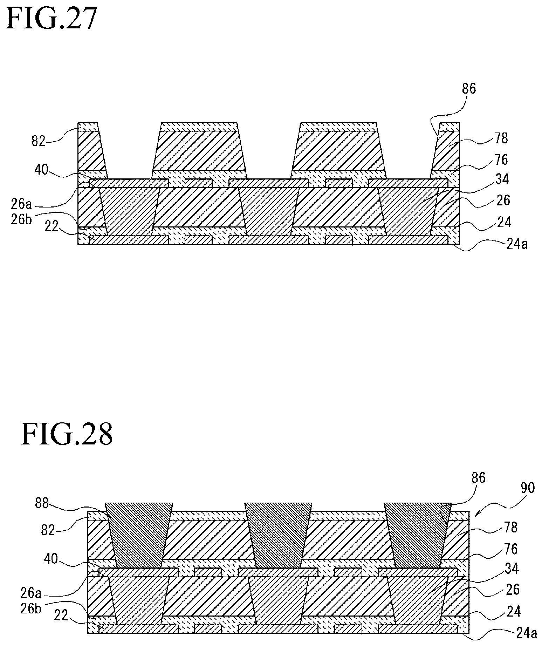

Then, as shown in Figs. 27 and 28, second vias 88 are formed in the fifth insulating layer 76, the sixth insulating layer 78, and the seventh insulating layer 82 (second via forming step). Specifically, as shown in Fig. 27, through-holes 86 are formed in the fifth insulating layer 76, the sixth insulating layer 78, and the seventh insulating layer 82. In one example, the through-holes 86 can be formed by laser processing. The types of laser processing include CO₂ laser, YAG laser, and the like, but they are not limited to these and can be appropriately selected depending on the purpose. Then, as shown in Fig. 28, the through-holes 86 are filled with conductive paste 88. The laminated body 90 is completed through the steps described above.

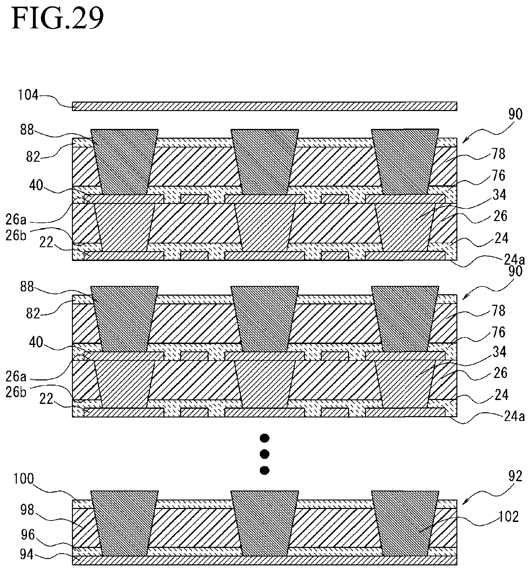

Then, as shown in Figs. 29 and 30, multiple laminated bodies 90 are stacked (fifth stacking step). More specifically, when the multilayer substrate 300 includes an even number of layers, a laminated body 92, multiple laminated bodies 90, and a metal layer 104 are stacked in this order and thermocompression-bonded. Furthermore, when the multilayer substrate 300 includes an odd number of layers, a laminated body (not shown) in which the second metal layer 22 is exposed from the second insulating layer 24 before etching, multiple laminated bodies 90, and the metal layer 104 are stacked in this order and then thermocompression-bonded. In either of the above cases, the second vias 54 in one laminated body 90 are electrically connected to the metal layer 104 or the second metal layer 22 of another laminated body 90.

Then, as shown in Fig. 31, etching is performed to form the metal layer 104 and the metal layer 94 of the multilayer substrate 300 after stacking (after thermocompression bonding) into a metal layer 108 and a metal layer 106 of a predetermined pattern.

### <Third Embodiment>

### <<Multilayer Substrate>>

The multilayer substrate 400 of a third embodiment is now described in detail. The multilayer substrate 400 of the third embodiment includes the first insulating layer 26 and an eighth insulating layer 120 instead of the first insulating layer 26 of the multilayer substrate 300 of the second embodiment. Also, at least the second insulating layer 24, the fifth insulating layer 76, the seventh insulating layer 82, and the eighth insulating layer 120 are made of a material with a low dielectric loss tangent. Other than the above, the configuration of the multilayer substrate 400 is similar to that of the multilayer substrate 300. The first insulating layer 26, the fifth insulating layer 76, and the eighth insulating layer 120 are described in detail below.

### <<<First Insulating Layer>>>

In the third embodiment, instead of a patterned metal layer being formed, the eighth insulating layer 120 is stacked on the first surface 26a of the first insulating layer 26. The first insulating layer 26 is preferably formed thinner than the first insulating layer 26 of the first and second embodiments by an amount corresponding to the stacking of the eighth insulating layer 120.

A patterned first metal layer 40 is formed on a fourth surface 120a of the eighth insulating layer 120 (that is, the surface of the eighth insulating layer 120 opposite to the first insulating layer 26). Accordingly, first vias 34 are formed to extend through the first insulating layer 26, the second insulating layer 24, and the eighth insulating layer 120, and are configured to electrically connect the first metal layer 40 and the second metal layer 22.

### <<<Eighth Insulating Layer>>>

Also, the eighth insulating layer 120 is made of a material with a low dielectric loss tangent. More specifically, the eighth insulating layer 120 preferably has a dielectric loss tangent of 0.002 or less at 10 GHz. Also, the eighth insulating layer 120 is preferably made of a material that exhibits adhesion to a metal layer that is not subjected to a roughening treatment. In other words, the eighth insulating layer 120 is in close contact with the first metal layer 40 (specifically, the back side of the first metal layer 40). In one example, as the eighth insulating layer 120, the same material as the second insulating layer 24 described above may be used, but is not limited to this and can be appropriately selected depending on the purpose.

The multilayer substrate 400 of the present embodiment described above can achieve high-speed transmission of each metal layer without requiring a roughening treatment or a chemical adhesion coating on the first metal layer 40 and the second metal layer 22.

### <<Method for Manufacturing Multilayer Substrate>>

The method for manufacturing a multilayer substrate of a third embodiment is now described in detail. The method for manufacturing the multilayer substrate 400 includes a laminated body forming step of forming a laminated body 130 and a fifth stacking step of stacking a plurality of laminated bodies 130. The method for manufacturing the multilayer substrate 400 of the third embodiment differs from the method for manufacturing the multilayer substrate 300 of the second embodiment in the second stacking step, the first via forming step, and the first metal layer forming step, but the other configurations are similar to those of the method for manufacturing the multilayer substrate 300 of the second embodiment.

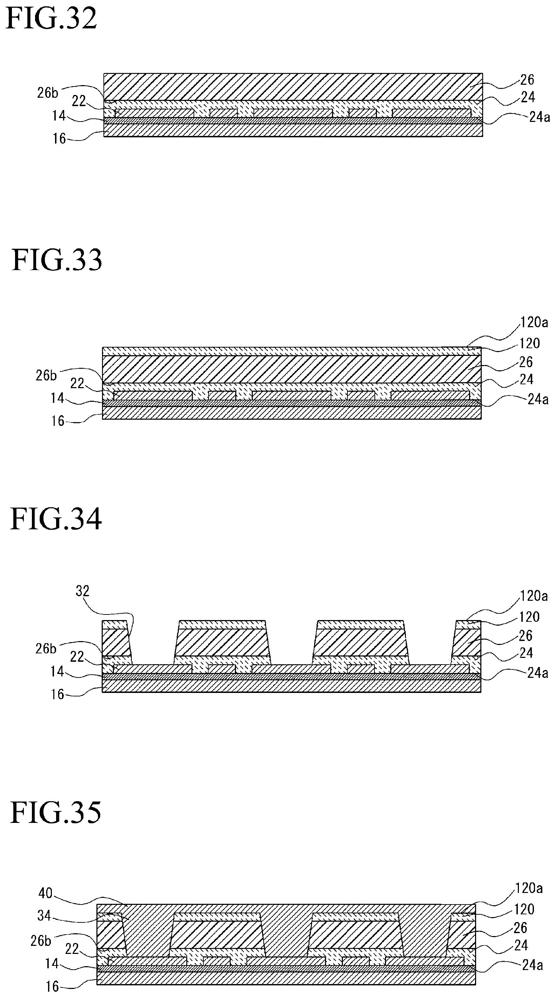

In the first stacking step of the third embodiment, as shown in Figs. 32 and 33, a first insulating layer (specifically, an uncured first insulating layer) 26 and an eighth insulating layer (specifically, an uncured eighth insulating layer) 120 are stacked on the second insulating layer 24 in this order.

Then, in the first via forming step of the third embodiment, as shown in Figs. 34 to 35, first vias 34 are formed in the first insulating layer 26 and the eighth insulating layer 120.

Specifically, first, as shown in Fig. 34, through-holes 32 are formed in the first insulating layer 26, the second insulating layer 24, and the eighth insulating layer 120. In one example, the through-holes 32 can be formed by laser processing. The types of laser processing include CO₂ laser, YAG laser, and the like, but they are not limited to these and can be appropriately selected depending on the purpose.

Then, as shown in Fig. 35, plating (copper plating) is applied to the through-holes 32 and the surface of the eighth insulating layer 120 by a plating process to form first vias (plated vias) 34. At this time, copper plating is also applied to the first vias 34 and the upper surface of the eighth insulating layer 120. Instead of plated vias, a conductive paste may be used for filling.

### <<<First Metal Layer Forming Step>>>

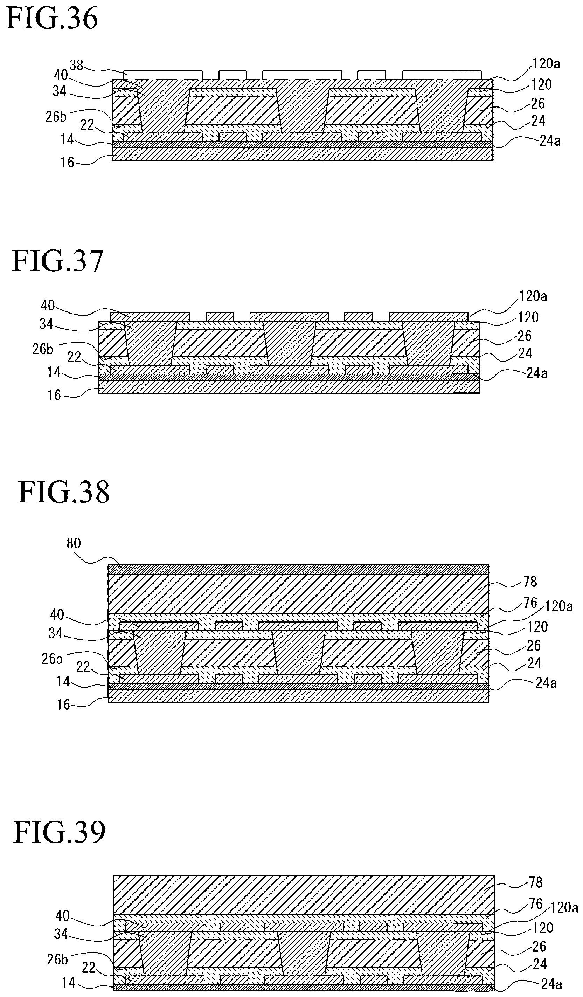

Then, in the first metal layer forming step of the third embodiment, the first metal layer 40 is formed on the first surface 120a of the eighth insulating layer 120, as shown in Figs. 36 to 37. The method for forming the first metal layer 40 can be performed in a similar manner as the first metal layer forming step in the first and second embodiments.

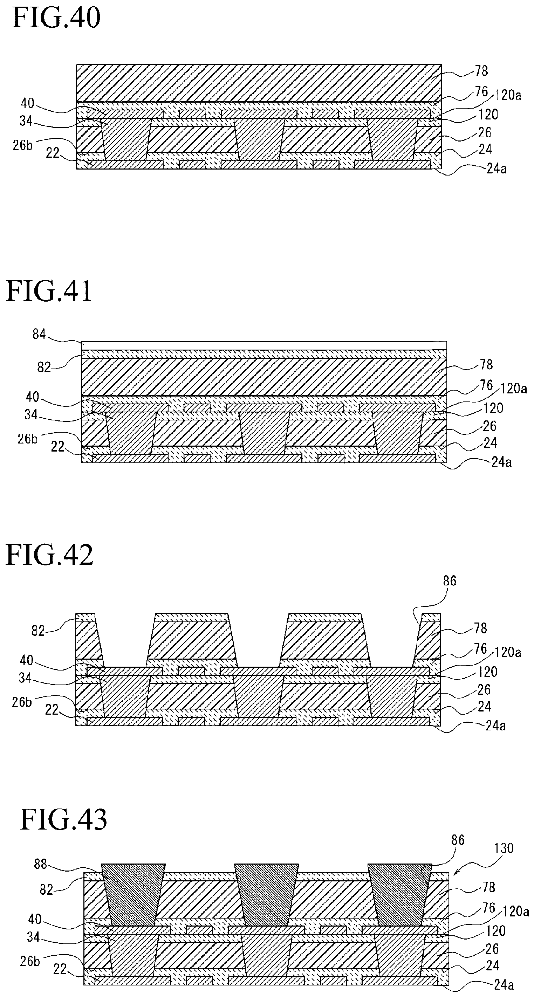

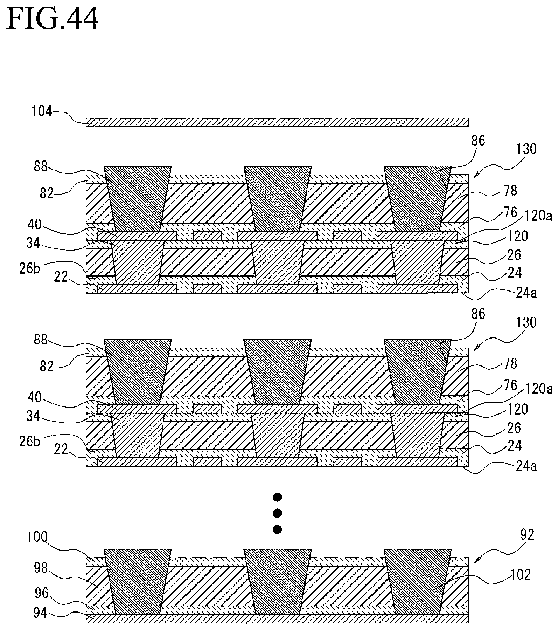

As shown in Figs. 38 to 46, the laminated body 130 can be obtained by sequentially performing the third stacking step and subsequent steps, and the multilayer substrate 400 can be formed by a fifth stacking step of stacking a plurality of laminated bodies 130.

### <Electronic Device>

An electronic device 500 in the embodiments is now described. The electronic device 500 includes at least the multilayer substrate 200, the multilayer substrate 300, or the multilayer substrate 400, and electronic components, and further includes other components as necessary.

The electronic device 500 is not particularly limited and can be appropriately selected depending on the purpose. Examples include personal computers (notebook computers, desktop computers), telephones, mobile phones, tablet-type mobile terminals, smartphones, copy machines, facsimiles, various printers, digital cameras, televisions, videos, CD devices, DVD devices, air conditioners, and remote control devices.

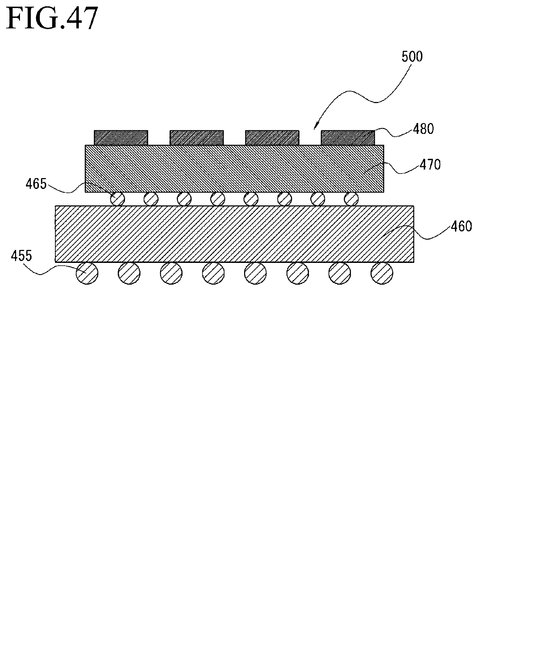

Fig. 47 shows a schematic cross-sectional view of a semiconductor package. The semiconductor package of Fig. 47 includes a motherboard 460 having solder balls 455, an interposer 470 connected onto the motherboard 460 via bumps 465, and semiconductor devices 480 placed on the interposer 470. The semiconductor device 480 may be, for example, a Field Programmable Gate Array (FPGA) chip.

The multilayer substrate 200, the multilayer substrate 300, or the multilayer substrate 400 can be used as the motherboard 460 in Fig. 47, as the interposer 470, and further as a circuit board forming the semiconductor device 480.

The present invention is not limited to the embodiments described above, and various modifications can be made without departing from the scope of the present invention. The following clauses are disclosed regarding the embodiments described above.

### (Clause 1)

A multilayer substrate, wherein a plurality of laminated bodies each including:
a first insulating layer having a first surface on which a patterned first metal layer is formed;
a second insulating layer that is stacked on a second surface of the first insulating layer and has a third surface that is opposite to the first insulating layer and on which a patterned second metal layer is formed and embedded;
a third insulating layer stacked on the first surface such that the first metal layer is embedded, and a fourth insulating layer stacked on the third insulating layer;
a first via that is formed to extend through the first insulating layer and the second insulating layer and electrically connects the first metal layer and the second metal layer; and
a second via formed to extend through the third insulating layer and the fourth insulating layer, are stacked, and
at least the second insulating layer and the fourth insulating layer are made of a material with a low dielectric loss tangent.

### (Clause 2)

The multilayer substrate according to clause 1, wherein the second insulating layer and the fourth insulating layer have a dielectric loss tangent of 0.002 or less at 10 GHz.

### (Clause 3)

The multilayer substrate according to clause 1 or 2, wherein the second metal layer is not subjected to a surface roughening treatment.

### (Clause 4)

A multilayer substrate, wherein a plurality of laminated bodies each including:
a first insulating layer having a first surface on which a patterned first metal layer is formed;
a second insulating layer that is stacked on a second surface of the first insulating layer and has a third surface that is opposite to the first insulating layer and on which a patterned second metal layer is formed and embedded;
a fifth insulating layer stacked on the first surface such that the first metal layer is embedded, a sixth insulating layer stacked on the fifth insulating layer, and a seventh insulating layer stacked on the sixth insulating layer;
a first via that is formed to extend through the first insulating layer and the second insulating layer and electrically connects the first metal layer and the second metal layer; and
a second via formed to extend through the fifth insulating layer, the sixth insulating layer, and the seventh insulating layer, are stacked, and
at least the second insulating layer, the fifth insulating layer, and the seventh insulating layer are made of a material with a low dielectric loss tangent.

### (Clause 5)

The multilayer substrate according to clause 4, wherein the second insulating layer, the fifth insulating layer, and the seventh insulating layer have a dielectric loss tangent of 0.002 or less at 10 GHz.

### (Clause 6)

The multilayer substrate according to clause 4 or clause 5, wherein the first metal layer and the second metal layer are not subjected to a surface roughening treatment.

### (Clause 7)

A multilayer substrate, wherein a plurality of laminated bodies each including:
a first insulating layer;
an eighth insulating layer that is stacked on a first surface of the first insulating layer and has a fourth surface that is opposite to the first insulating layer and on which a patterned first metal layer is formed;
a second insulating layer that is stacked on a second surface of the first insulating layer and has a third surface that is opposite to the first insulating layer and on which a patterned second metal layer is formed and embedded;
a fifth insulating layer stacked on the fourth surface such that the first metal layer is embedded, a sixth insulating layer stacked on the fifth insulating layer, and a seventh insulating layer stacked on the sixth insulating layer;
a first via that is formed to extend through the first insulating layer, the second insulating layer, and the eighth insulating layer and electrically connects the first metal layer and the second metal layer; and
a second via formed to extend through the fifth insulating layer, the sixth insulating layer, and the seventh insulating layer, are stacked, and
at least the second insulating layer, the fifth insulating layer, the seventh insulating layer, and the eighth insulating layer are made of a material with a low dielectric loss tangent.

### (Clause 8)

The multilayer substrate according to clause 7, wherein the second insulating layer, the fifth insulating layer, the seventh insulating layer, and the eighth insulating layer have a dielectric loss tangent of 0.002 or less at 10 GHz.

### (Clause 9)

The multilayer substrate according to clause 7 or clause 8, wherein the first metal layer and the second metal layer are not subjected to a surface roughening treatment.

### (Clause 10)

A method for manufacturing a multilayer substrate, the method comprising:
a laminated body forming step of forming a laminated body by
a second metal layer forming step of forming a second metal layer by performing etching on a three-layer metal foil,
then, a first stacking step of stacking a second insulating layer on the second metal layer so as to embed the second metal layer,
then, a second stacking step of stacking a first insulating layer on the second insulating layer,
then, a first via forming step of forming a first via in the first insulating layer and the second insulating layer,
then, a first metal layer forming step of forming a first metal layer on the first insulating layer,
then, a third stacking step of stacking a third insulating layer such that the first metal layer is embedded,
then, an etching step of removing a portion other than the second metal layer by performing etching on the three-layer metal foil,
then, a fourth stacking step of stacking a fourth insulating layer on the third insulating layer, and
then, a second via forming step of forming a second via in the third insulating layer and the fourth insulating layer; and
a fifth stacking step of stacking a plurality of the laminated bodies, wherein
at least the second insulating layer and the fourth insulating layer are made of a material with a low dielectric loss tangent.

### (Clause 11)

The method for manufacturing a multilayer substrate according to clause 10, wherein the second insulating layer and the fourth insulating layer have a dielectric loss tangent of 0.002 or less at 10 GHz.

### (Clause 12)

A method for manufacturing a multilayer substrate, the method comprising:
a laminated body forming step of forming a laminated body by
a second metal layer forming step of forming a second metal layer by performing etching on a three-layer metal foil,
then, a first stacking step of stacking a second insulating layer on the second metal layer so as to embed the second metal layer,
then, a second stacking step of stacking a first insulating layer on the second insulating layer,
then, a first via forming step of forming a first via in the first insulating layer and the second insulating layer,
then, a first metal layer forming step of forming a first metal layer on the first insulating layer,
then, a third stacking step of stacking a fifth insulating layer and a sixth insulating layer such that the first metal layer is embedded,
then, an etching step of removing a portion other than the second metal layer by performing etching on the three-layer metal foil,
then, a fourth stacking step of stacking a seventh insulating layer on the sixth insulating layer, and
then, a second via forming step of forming a second via in the fifth insulating layer, the sixth insulating layer, and the seventh insulating layer; and
a fifth stacking step of stacking a plurality of the laminated bodies, wherein
at least the second insulating layer, the fifth insulating layer, and the seventh insulating layer are made of a material with a low dielectric loss tangent.

### (Clause 13)

The method for manufacturing a multilayer substrate according to clause 12, wherein the second insulating layer, the fifth insulating layer, and the seventh insulating layer have a dielectric loss tangent of 0.002 or less at 10 GHz.

### (Clause 14)

A method for manufacturing a multilayer substrate, the method comprising:
a laminated body forming step of forming a laminated body by
a second metal layer forming step of forming a second metal layer by performing etching on a three-layer metal foil,
then, a first stacking step of stacking a second insulating layer on the second metal layer so as to embed the second metal layer,
then, a second stacking step of stacking a first insulating layer and an eighth insulating layer on the second insulating layer,
then, a first via forming step of forming a first via in the first insulating layer, the second insulating layer, and the eighth insulating layer,
then, a first metal layer forming step of forming a first metal layer on the eighth insulating layer,
then, a third stacking step of stacking a fifth insulating layer and a sixth insulating layer such that the first metal layer is embedded,
then, an etching step of removing a portion other than the second metal layer by performing etching on the three-layer metal foil,
then, a fourth stacking step of stacking a seventh insulating layer on the sixth insulating layer, and
then, a second via forming step of forming a second via in the fifth insulating layer, the sixth insulating layer, and the seventh insulating layer; and
a fifth stacking step of stacking a plurality of the laminated bodies, wherein
at least the second insulating layer, the fifth insulating layer, the seventh insulating layer, and the eighth insulating layer are made of a material with a low dielectric loss tangent.

### (Clause 15)

The method for manufacturing a multilayer substrate according to clause 14, wherein the second insulating layer, the fifth insulating layer, the seventh insulating layer, and the eighth insulating layer have a dielectric loss tangent of 0.002 or less at 10 GHz.

### (Clause 16)

An electronic device comprising the multilayer substrate according to clause 1, clause 4, or clause 7 and an electronic component.

## Claims

1. A multilayer substrate, wherein a plurality of laminated bodies each including:
a first insulating layer having a first surface on which a patterned first metal layer is formed;
a second insulating layer that is stacked on a second surface of the first insulating layer and has a third surface that is opposite to the first insulating layer and on which a patterned second metal layer is formed and embedded;
a third insulating layer stacked on the first surface such that the first metal layer is embedded, and a fourth insulating layer stacked on the third insulating layer;
a first via that is formed to extend through the first insulating layer and the second insulating layer and electrically connects the first metal layer and the second metal layer; and
a second via formed to extend through the third insulating layer and the fourth insulating layer, are stacked, and
at least the second insulating layer and the fourth insulating layer are made of a material with a low dielectric loss tangent.

2. The multilayer substrate according to claim 1, wherein the second insulating layer and the fourth insulating layer have a dielectric loss tangent of 0.002 or less at 10 GHz.

3. The multilayer substrate according to claim 1 or 2, wherein the second metal layer is not subjected to a surface roughening treatment.

4. A multilayer substrate, wherein a plurality of laminated bodies each including:
a first insulating layer having a first surface on which a patterned first metal layer is formed;
a second insulating layer that is stacked on a second surface of the first insulating layer and has a third surface that is opposite to the first insulating layer and on which a patterned second metal layer is formed and embedded;
a fifth insulating layer stacked on the first surface such that the first metal layer is embedded, a sixth insulating layer stacked on the fifth insulating layer, and a seventh insulating layer stacked on the sixth insulating layer;
a first via that is formed to extend through the first insulating layer and the second insulating layer and electrically connects the first metal layer and the second metal layer; and
a second via formed to extend through the fifth insulating layer, the sixth insulating layer, and the seventh insulating layer, are stacked, and
at least the second insulating layer, the fifth insulating layer, and the seventh insulating layer are made of a material with a low dielectric loss tangent.

5. The multilayer substrate according to claim 4, wherein the second insulating layer, the fifth insulating layer, and the seventh insulating layer have a dielectric loss tangent of 0.002 or less at 10 GHz.

6. The multilayer substrate according to claim 4 or claim 5, wherein the first metal layer and the second metal layer are not subjected to a surface roughening treatment.

7. A multilayer substrate, wherein a plurality of laminated bodies each including:
a first insulating layer;
an eighth insulating layer that is stacked on a first surface of the first insulating layer and has a fourth surface that is opposite to the first insulating layer and on which a patterned first metal layer is formed;
a second insulating layer that is stacked on a second surface of the first insulating layer and has a third surface that is opposite to the first insulating layer and on which a patterned second metal layer is formed and embedded;
a fifth insulating layer stacked on the fourth surface such that the first metal layer is embedded, a sixth insulating layer stacked on the fifth insulating layer, and a seventh insulating layer stacked on the sixth insulating layer;
a first via that is formed to extend through the first insulating layer, the second insulating layer, and the eighth insulating layer and electrically connects the first metal layer and the second metal layer; and
a second via formed to extend through the fifth insulating layer, the sixth insulating layer, and the seventh insulating layer, are stacked, and
at least the second insulating layer, the fifth insulating layer, the seventh insulating layer, and the eighth insulating layer are made of a material with a low dielectric loss tangent.

8. The multilayer substrate according to claim 7, wherein the second insulating layer, the fifth insulating layer, the seventh insulating layer, and the eighth insulating layer have a dielectric loss tangent of 0.002 or less at 10 GHz.

9. The multilayer substrate according to claim 7 or claim 8, wherein the first metal layer and the second metal layer are not subjected to a surface roughening treatment.

10. A method for manufacturing a multilayer substrate, the method comprising:
a laminated body forming step of forming a laminated body by
a second metal layer forming step of forming a second metal layer by performing etching on a three-layer metal foil,
then, a first stacking step of stacking a second insulating layer on the second metal layer so as to embed the second metal layer,
then, a second stacking step of stacking a first insulating layer on the second insulating layer,
then, a first via forming step of forming a first via in the first insulating layer and the second insulating layer,
then, a first metal layer forming step of forming a first metal layer on the first insulating layer,
then, a third stacking step of stacking a third insulating layer such that the first metal layer is embedded,
then, an etching step of removing a portion other than the second metal layer by performing etching on the three-layer metal foil,
then, a fourth stacking step of stacking a fourth insulating layer on the third insulating layer, and
then, a second via forming step of forming a second via in the third insulating layer and the fourth insulating layer; and
a fifth stacking step of stacking a plurality of the laminated bodies, wherein
at least the second insulating layer and the fourth insulating layer are made of a material with a low dielectric loss tangent.

11. The method for manufacturing a multilayer substrate according to claim 10, wherein the second insulating layer and the fourth insulating layer have a dielectric loss tangent of 0.002 or less at 10 GHz.

12. A method for manufacturing a multilayer substrate, the method comprising:
a laminated body forming step of forming a laminated body by
a second metal layer forming step of forming a second metal layer by performing etching on a three-layer metal foil,
then, a first stacking step of stacking a second insulating layer on the second metal layer so as to embed the second metal layer,
then, a second stacking step of stacking a first insulating layer on the second insulating layer,
then, a first via forming step of forming a first via in the first insulating layer and the second insulating layer,
then, a first metal layer forming step of forming a first metal layer on the first insulating layer,
then, a third stacking step of stacking a fifth insulating layer and a sixth insulating layer such that the first metal layer is embedded,
then, an etching step of removing a portion other than the second metal layer by performing etching on the three-layer metal foil,
then, a fourth stacking step of stacking a seventh insulating layer on the sixth insulating layer, and
then, a second via forming step of forming a second via in the fifth insulating layer, the sixth insulating layer, and the seventh insulating layer; and
a fifth stacking step of stacking a plurality of the laminated bodies, wherein
at least the second insulating layer, the fifth insulating layer, and the seventh insulating layer are made of a material with a low dielectric loss tangent.

13. The method for manufacturing a multilayer substrate according to claim 12, wherein the second insulating layer, the fifth insulating layer, and the seventh insulating layer have a dielectric loss tangent of 0.002 or less at 10 GHz.

14. A method for manufacturing a multilayer substrate, the method comprising:
a laminated body forming step of forming a laminated body by
a second metal layer forming step of forming a second metal layer by performing etching on a three-layer metal foil,
then, a first stacking step of stacking a second insulating layer on the second metal layer so as to embed the second metal layer,
then, a second stacking step of stacking a first insulating layer and an eighth insulating layer on the second insulating layer,
then, a first via forming step of forming a first via in the first insulating layer, the second insulating layer, and the eighth insulating layer,
then, a first metal layer forming step of forming a first metal layer on the eighth insulating layer,
then, a third stacking step of stacking a fifth insulating layer and a sixth insulating layer such that the first metal layer is embedded,
then, an etching step of removing a portion other than the second metal layer by performing etching on the three-layer metal foil,
then, a fourth stacking step of stacking a seventh insulating layer on the sixth insulating layer, and
then, a second via forming step of forming a second via in the fifth insulating layer, the sixth insulating layer, and the seventh insulating layer; and
a fifth stacking step of stacking a plurality of the laminated bodies, wherein
at least the second insulating layer, the fifth insulating layer, the seventh insulating layer, and the eighth insulating layer are made of a material with a low dielectric loss tangent.

15. The method for manufacturing a multilayer substrate according to claim 14, wherein the second insulating layer, the fifth insulating layer, the seventh insulating layer, and the eighth insulating layer have a dielectric loss tangent of 0.002 or less at 10 GHz.

16. An electronic device comprising the multilayer substrate according to claim 1, claim 4, or claim 7 and an electronic component.
